(19) Europäisches Patentamt
European Patent Office
Office européen des brevets

(11) **EP 1 349 970 B1**

(12) **FASCICULE DE BREVET EUROPEEN**

(45) Date de publication et mention
de la délivrance du brevet:
**12.10.2011 Bulletin 2011/41**

(21) Numéro de dépôt: **01993718.4**

(22) Date de dépôt: **12.11.2001**

(51) Int Cl.:
**C30B 11/00** *(2006.01)* **C30B 29/48** *(2006.01)*

(86) Numéro de dépôt international:
**PCT/FR2001/003519**

(87) Numéro de publication internationale:
**WO 2002/038837 (16.05.2002 Gazette 2002/20)**

(54) **PROCEDE DE CROISSANCE D'UN MATERIAU SEMI-CONDUCTEUR MASSIF DE TYPE II-VI**

VERFAHREN ZUR ZÜCHTUNG VON II-VI HALBLEITERWERKSTOFF IN BULKFORM

METHOD FOR GROWING A SOLID TYPE II-VI SEMICONDUCTOR MATERIAL

(84) Etats contractants désignés:
**DE GB IT**

(30) Priorité: **13.11.2000 FR 0014539**

(43) Date de publication de la demande:
**08.10.2003 Bulletin 2003/41**

(73) Titulaire: **Commissariat à l'Énergie Atomique et aux Énergies Alternatives**
**75015 Paris (FR)**

(72) Inventeur: **PELLICIARI, Bernard**
**F-38120 SAINT-EGREVE (FR)**

(74) Mandataire: **Poulin, Gérard et al**
**BREVALEX**
**95 rue d'Amsterdam**
**75378 Paris Cedex 8 (FR)**

(56) Documents cités:
**EP-A- 0 244 987    EP-A- 0 261 647**

- **VERE ET AL.: "Growth of CdTe by solvent evaporation" JOURNAL OF CRYSTAL GROWTH., vol. 72, 1985, pages 97-101, XP002171978 NORTH-HOLLAND PUBLISHING CO. AMSTERDAM., NL ISSN: 0022-0248 cité dans la demande**
- **MULLIN ET AL.: "Crystal growth and characterisation of cadmium telluride...." JOURNAL OF CRYSTAL GROWTH., vol. 59, 1982, pages 135-142, XP002171979 NORTH-HOLLAND PUBLISHING CO. AMSTERDAM., NL ISSN: 0022-0248 cité dans la demande**
- **BUTLER J F ET AL: "GAMMA- AND X-RAY DETECTORS MANUFACTURED FROM CD1-XZNXTE GROWN BY A HIGH PRESSURE BRIDGMAN METHOD" MATERIALS SCIENCE AND ENGINEERING B,CH,ELSEVIER SEQUOIA, LAUSANNE, vol. B16, no. 1 / 03, 30 janvier 1993 (1993-01-30), pages 291-295, XP000360005 ISSN: 0921-5107**

EP 1 349 970 B1

## Description

## Domaine technique

La présente invention concerne un procédé de croissance d'un matériau semi-conducteur massif de type II-VI. Elle s'applique notamment à l'obtention de plaques de CdTe ou de CdZnTe de grandes dimensions. De telles plaques peuvent être utilisées dans la fabrication de détecteurs élémentaires ou matriciels pour l'imagerie X et γ.

## Etat de la technique antérieure

Actuellement, la demande en détecteurs X et γ est de plus en plus grande que ce soit sous forme de détecteurs élémentaires ou sous forme d'imageurs monodimensionnels ou bidimensionnels de grande surface. Ces dispositifs utilisent généralement le matériau CdTe (ou mieux CdZnTe) obtenu soit par la méthode THM (pour "Travelling Heater Method") avec un dopage au chlore, soit par la méthode HPB (pour "High Pressure Bridgman") avec un dopage approprié. Toutefois, ces deux méthodes présentent un certain nombre d'inconvénients. L'uniformité des propriétés électriques n'est pas maîtrisée. La reproductibilité d'un tirage à l'autre est mal assurée. La méthode THM utilise un tube fermé et fournit des lingots limités à un diamètre de 2 pouces (5,08 cm) et de valeur de résistivité limitée à $10^9$ Ω.cm. La méthode HPB utilise un autoclave et fournit des lingots de 4 pouces (10,16 cm) de diamètre mais avec une taille des grains très aléatoire. Elle nécessite une pression élevée (de l'ordre de 100 atmosphères), ce qui est très contraignant. Enfin, les lingots ont une valeur de résistivité voisine de $10^{10}$ Ω.cm mais non uniforme le long du lingot.

Le tellurure de cadmium peut aussi être obtenu par évaporation de solvant. Les articles suivants se rapportent à la croissance de cristaux de CdTe suivant ce principe :

- "Préparation of CdTe Crystals from Near Stoichiometric and Cd Rich Melt Compositions under Constant Cd Pressure" par M.R. LORENZ, paru dans Journal of Applied Physics, Vol. 33, N° 11, novembre 1962, pages 3304-3306 ;
- "Growth of Cadmium Telluride by Solvent Evaporation" par B. LUNN et al., paru dans la Revue de Physique Appliquée, tome 12, février 1977, pages 151-154 ;
- "Crystal Growth and Characterisation of Cadmium Telluride : a Modified Solvent Evaporation Technique" par J.B. MULLIN et al., paru dans Journal of Crystal Growth 59 (1982), pages 135-142 ;
- "Growth of CdTe by Solvent Evaporation" par A.W. VERE et al., paru dans Journal of Crystal Growth 72 (1985), pages 97-101.

Ces articles font état de l'utilisation du cadmium comme solvant et d'une croissance cristalline réalisée dans un tube de quartz scellé dans lequel un vide poussé (inférieur à $10^{-6}$ atmosphère) est préalablement fait. La nécessité de contrôler la pression de cadmium impose d'introduire dans le tube (ou ampoule), avant son scellement, une source de cadmium. De ce fait, LORENZ est amené à concevoir un système expérimental à trois zones de températures qui ne peuvent pas être indépendantes et avec déplacement de l'ampoule de quartz. Les auteurs des trois autres articles ont choisi un système à deux zones de températures qui ne peuvent pas être indépendantes et sans déplacement de l'ampoule de quartz. Une zone est centrée sur le creuset où se produit la croissance, l'autre sur la source de cadmium.

Jusqu'à présent, la croissance de CdTe massif s'est faite par la méthode dite du tube fermé. La méthode dite du tube ouvert était jusqu'à présent réservée à la croissance de couches minces de CdTe sur un substrat. La croissance d'un cristal massif et la croissance d'une couche mince sur un substrat appartiennent à deux domaines différents de la métallurgie des semi-conducteurs de type II-VI.

Le problème qui se pose est donc d'obtenir des cristaux de matériau semi-conducteur de type II-VI (notamment de CdTe et de CdZnTe), massif, de grande dimension et de haute résistivité, selon un procédé de croissance peu contraignant.

## Exposé de l'invention

L'invention permet d'apporter une solution à ce problème en proposant un procédé de croissance permettant la production de plaques de matériau semi-conducteur massif de type II-VI, d'un diamètre supérieur à 10 cm et de résistivité très élevée (supérieure à $10^9$ Ω.cm) .

L'invention a donc pour objet un procédé de croissance d'un matériau massif semi-conducteur de type II-VI comprenant au moins un premier composant et un deuxième composant, le procédé comprenant les étapes suivantes :

- fourniture dans un creuset d'une charge comprenant lesdits composants, les proportions des composants dans la charge étant telles que le premier composant sert de solvant,
- mise en place du creuset dans un réacteur du type dit "tube ouvert",
- montée en température du réacteur pour obtenir un profil de température dans le réacteur assurant la fusion de la charge dans le creuset et amorçant l'évaporation du premier composant servant de solvant, la pression à l'intérieur du réacteur étant ajustée, par circulation d'un gaz, pour que les pressions partielles des composants à la température de croissance soient inférieures à la pression atmosphérique, la pression partielle du premier composant étant supérieure à la pression partielle du deuxième composant, le profil de température étant tel que la charge fondue est gardée à la température de croissance, égale ou légèrement supérieure à sa température d'équilibre et inférieure à la température de fusion du matériau désiré, le profil de température étant aussi tel que le creuset présente un point froid où se produit la germination et la croissance du matériau, le réacteur possédant également un point froid permettant la condensation du solvant.

Selon un mode de réalisation préféré, la montée en température se fait en deux périodes successives :

- une première période pendant laquelle le profil de température est tel que la charge dans le creuset commence à fondre et le premier composant à s'évaporer, une zone du réacteur située entre le creuset et le point froid permettant la condensation du solvant étant portée à une température supérieure à la température du creuset afin de constituer un bouchon thermique ;
- une deuxième période pendant laquelle la charge du creuset est portée à ladite température de croissance, ladite zone du réacteur située entre le creuset et le point froid du réacteur se trouvant à une température inférieure à la température de croissance pour permettre la condensation du solvant.

Avantageusement, le profil de température est assuré par un four possédant deux zones de chauffe. De préférence, le profil de température est assuré dans un four vertical possédant une zone de chauffe supérieure, correspondant à la position du creuset, et une zone de chauffe inférieure située entre la position du creuset et le point froid du réacteur.

La température de croissance peut en particulier être une température constante.

La pression à l'intérieur du réacteur peut être ajustée en fonction de la vitesse d'évaporation désirée pour le solvant. Ceci permet de contrôler la vitesse de croissance du matériau semi-conducteur.

La pression à l'intérieur du réacteur peut être ajustée par circulation d'argon.

La charge fournie dans le creuset peut comprendre également au moins une impureté dopante dont la pression de vapeur est inférieure à la pression de vapeur des composants.

La charge fournie dans le creuset peut comprendre également au moins une impureté dopante choisie parmi Ti, V, Cr, Mn, Fe, Co, Ni, Cu, Ga, Ge, Al, In, Ag, Au, Tl, Si, Sn, Pb, Bi, Li, Na, K, Be, Mg et Ca.

Au moment de la fourniture de ladite charge dans le creuset, un germe peut être introduit au fond du creuset pour favoriser la monocristallisation.

L'invention s'applique notamment à l'obtention de CdTe massif. Dans ce cas, le premier composant est du tellure et le deuxième composant est du cadmium.

L'invention s'applique notamment encore à l'obtention de CdZnTe massif. Dans ce cas, le matériau semi-conducteur comprend aussi un troisième composant qui est le zinc.

**Brève description des dessins**

L'invention sera mieux comprise et d'autres avantages et particularités apparaîtront à la lecture de la description qui va suivre, donnée à titre d'exemple non limitatif, accompagnée des dessins annexés parmi lesquels :

- La figure 1 représente le diagramme de phase complet d'un mélange CdTe,
- la figure 2A est une vue en coupe longitudinale et schématique d'un dispositif pour la mise en oeuvre du procédé selon l'invention,
- les figures 2B et 2C représentent des diagrammes de température associés au dispositif de la figure 2A,
- la figure 3 représente un diagramme de phase partiel, côté tellure, d'un mélange CdTe illustrant de la croissance d'un cristal de CdTe selon l'invention.

**Description détaillée de modes de réalisation de l'invention**

La suite de la description va porter sur la croissance de CdTe massif. Cependant, l'invention s'applique à la croissance d'autres matériaux semi-conducteurs de type II-VI comprenant au moins un premier composant et un deuxième composant.

Selon l'invention, la croissance cristalline s'effectue dans un réacteur en tube ouvert ne présentant qu'une seule zone de température à contrôler. Dans le cas du CdTe, c'est le tellure qui servira de solvant.

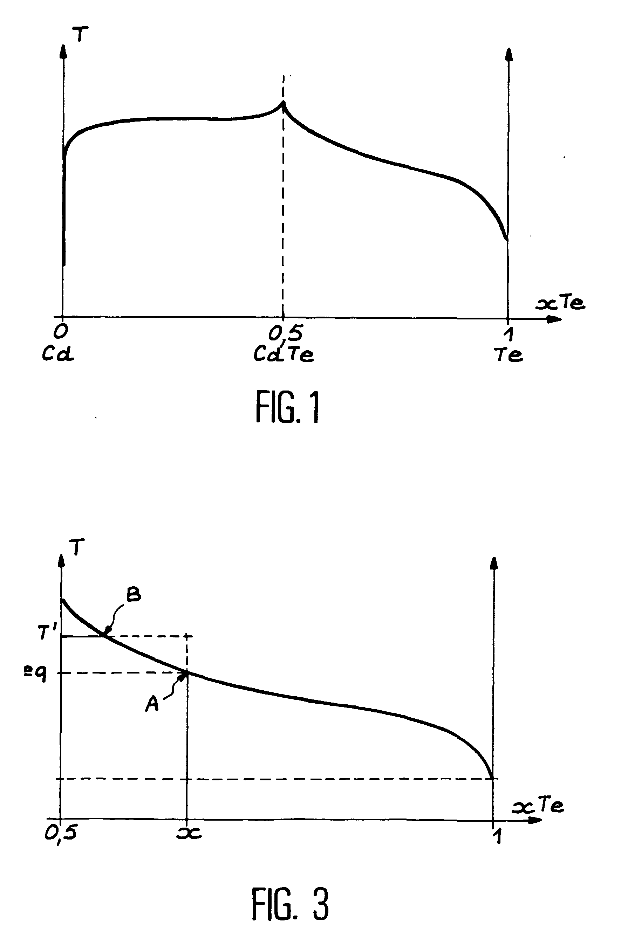

La figure 1 représente le diagramme de phase complet d'un mélange de CdTe en fonction de la température T. L'axe des abscisses représente la proportion des composants dans le mélange. Pour x = 0, il n'y a que du cadmium pur. Pour x = 1, il n'y a que du tellure pur. Ce diagramme fait apparaître que le tellure peut être plus judicieusement choisi que le cadmium comme solvant du CdTe car il présente une meilleure solubilité à toutes températures. De plus, les solutions riches en tellure ont des pressions partielles d'équilibre bien plus faibles que celles mises en jeu côté cadmium. Par exemple, autour de la température de 1040°C, côté tellure, on a la relation suivante :

$$P_{Cd} < P_{Te_2} < 0,18 \text{ atm.}$$

Côté cadmium, on a la relation suivante :

$$P_{Te_2} < P_{Cd} < 6,5 \text{ atm.}$$

D'après cet exemple, la pression partielle de cadmium est plus d'une décade plus faible côté tellure que côté cadmium. L'obligation faite aux auteurs des quatre articles cités plus haut d'ajouter une source de cadmium auxiliaire, et ainsi de contrôler une deuxième zone de température, n'est pas de mise côté tellure. Ceci présente un avantage de simplification dans la mise en oeuvre.

La condition des faibles pressions partielles de Cd et Te mises en jeu côté tellure donne la possibilité d'utiliser un tube ouvert au lieu d'un tube fermé, ce qui est nettement avantageux pour la mise en oeuvre du procédé de croissance. Dans ce domaine technique, l'expression tube fermé désigne un tube scellé au début de l'opération de croissance. L'expression tube ouvert signifie que le tube servant de réacteur est fermé par un flasque qui permet des communications avec l'extérieur. Dans ce cas, les conditions de croissance peuvent être modifiées au cours de la croissance contrairement au réacteur en tube fermé où les conditions de croissance sont figées au départ.

Le réacteur en tube ouvert utilisé pour la mise en oeuvre du procédé selon l'invention possède un point suffisamment froid pour condenser toute la vapeur issue de la charge située au point chaud. La température réelle de ce point froid est cependant sans importance.

En toute rigueur, une faible part de cadmium est aussi perdue par évaporation mais son effet sur la composition du mélange est largement négligeable devant celui causé par la perte de tellure compte tenu du rapport des pressions partielles.

Le réacteur fonctionne sous pression résiduelle dynamique à une valeur proche de l'atmosphère. Ceci permet d'éviter toute contamination de la vapeur ambiante par des impuretés désorbant de la paroi du tube réacteur ou susceptibles d'entrer dans le tube par une éventuelle microfuite au niveau du flasque de fermeture.

La pression interne ne doit, en tout état de cause, jamais être inférieure aux pressions partielles du cadmium et du tellure, ceci afin d'éviter toute ébullition de la solution liquide. Cependant, sa valeur peut être ajustée afin de réduire ou d'augmenter la vitesse d'évaporation du solvant tellure.

La valeur de la pression autour de l'atmosphère simplifie beaucoup l'environnement expérimental, par comparaison à la méthode HPB qui nécessite un autoclave supportant une pression de l'ordre de 100 atmosphères.

L'invention permet l'utilisation d'un réacteur ne présentant qu'une zone thermique à contrôler : seule la zone thermique centrée sur le creuset contenant la charge doit être contrôlée de manière précise. Selon un mode de mise en oeuvre préférentiel du procédé, la zone thermique du creuset est soumise à une température dont la valeur est inférieure à la valeur maximale du profil de température et supérieure à la température de fusion de la charge afin que cette dernière puisse devenir totalement liquide. Le passage à l'étape de croissance se fait par montée progressive de cette zone à une température légèrement supérieure à la température $T_{max}$ du profil précédent.

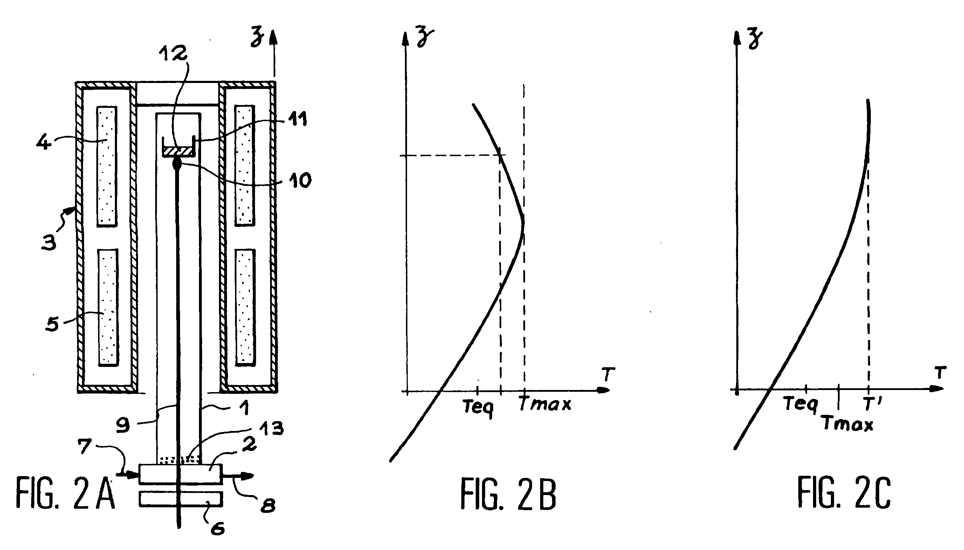

La figure 2A représente un dispositif pour la mise en oeuvre de l'invention. Ce dispositif se présente selon une disposition verticale. Il comprend un réacteur tubulaire 1 en quartz, fermé à son extrémité supérieure et équipé, à l'extrémité inférieure, d'une tête de fermeture 2. Le réacteur tubulaire 1 est introduit par le bas dans un four vertical 3 possédant une zone de chauffe supérieure 4 et une zone de chauffe inférieure 5. La tête de fermeture 2 comprend également, outre le flasque étanche 6, un piquage 7 utilisable comme entrée de gaz ainsi qu'un piquage 8 utilisable comme ligne d'évent. Le flasque de fermeture 6 est équipé en son centre d'un passage à joint torique permettant d'introduire, au moyen d'une tige de manoeuvre 9, un thermocouple 10 de mesure de la température au plus près du creuset 11 contenant la charge 12.

La position du creuset 11 dans le réacteur tubulaire 1 est réglé par un système de cannes de quartz non représenté de manière à placer le creuset 11 dans la zone de chauffe supérieure 4.

La figure 2B, associée à la figure 2A, montre un profil thermique préférentiel lors de la fusion de la charge placée dans le creuset. L'axe des ordonnées correspond à la dimension longitudinale z du réacteur tubulaire. L'axe des abscisses correspond à la température à l'intérieur du réacteur. Ce profil thermique, obtenu grâce aux zones de chauffage 4 et 5, montre que la température du creuset est inférieure à la température $T_{max}$ d'une zone inférieure au creuset. Ceci permet de maintenir l'équilibre thermodynamique entre la vapeur émanant du creuset et la charge. En effet, la zone portée à la température $T_{max}$ constitue un bouchon thermique, ce qui évite la perte de matière au cours de cette étape.

Au départ de la croissance cristalline, la température T' du creuset doit être au moins égale ou légèrement supérieure (de 2 à 10°C par exemple) à la température d'équilibre $T_{eq}$ de la composition choisie pour le mélange de cadmium et de tellure de départ. Le profil thermique de la figure 2C montre qu'au départ de la croissance cristalline le bouchon thermique n'existe plus. Le solvant tellure peut alors fuir vers le point le plus froid du réacteur, c'est-à-dire vers la tête de fermeture 2 où il se forme un dépôt de tellure 13.

La présence d'un gaz dans le réacteur, maintenu à une pression voisine de l'atmosphère ne change en rien le sens du transport de solvant. Ce gaz peut être de l'hydrogène, un mélange hydrogène-argon, de l'argon ou de l'hélium qui sont inertes pour le tellure. La circulation de ce gaz, grâce aux piquages 7 et 8, à un débit de 400 cm$^3$/minute a comme fonction d'en assurer le renouvellement.

La figure 3 représente un diagramme de phase partiel, côté tellure, d'un mélange CdTe. Pour obtenir un cristal de CdTe, la charge du creuset présente la composition imposée par l'abscisse x. Le diagramme de phase n'étant pas parfait, la température d'équilibre pour une composition donnée (indiquée par le point A) est incertaine. Pour cette raison, le creuset est porté à une température T' légèrement supérieure à la température d'équilibre. A cette température, tout le mélange est liquide. La solution, dont la composition est représentée par le point A sur le diagramme, perd du tellure par évaporation et s'enrichit donc en cadmium. Sur le diagramme de phase, ceci correspond à un déplacement depuis le point A correspondant à la température d'équilibre $T_{eq}$ jusqu'au point B correspondant à la température T' fixée par la zone de chauffage supérieure du four. Au point B, la composition ne peut plus évoluer puisque la température est bloquée. Il se crée ainsi la sursaturation nécessaire à la germination amorçant la cristallisation à la composition CdTe. Cette germination et la croissance cristalline démarrent au fond du creuset où un point froid est assuré grâce à un léger gradient de température (voir la figure 2C).

La croissance de CdTe progresse ainsi tant que la totalité du solvant n'a pas été évaporée. Elle cesse dès qu'il n'y a plus de solvant tellure. Le retour à la température ambiante peut alors être amorcé par baisse programmée de la température des zones chauffantes.

Par cette méthode, la croissance cristalline se fait à température constante à partir d'une solution à concentration constante et sans déplacement mécanique d'aucune sorte. Les conditions de stabilité thermique sont donc optimales et constantes tout le long de l'étape de croissance. De plus, il est possible d'ajouter certaines impuretés dopantes au départ. Ces impuretés doivent avoir une très faible tension de vapeur pour ne pas être évaporées en même temps que le solvant. Pour les matériaux de type II-VI, les impuretés utilisables sont Ti, V, Cr, Mn, Fe, Co, Ni, Cu, Ga, Ge, Al, In, Ag, Au, Tl, Si, Sn, Pb, Bi et les alcalins Li, Na, K, Be, Mg et Ca.

En outre, il peut être judicieux d'introduire au fond du creuset, au moment du chargement, un germe pour favoriser la monocristallisation. Ce germe peut être un monocristal orienté, par exemple du CdTe ou tout autre substrat insoluble dans la solution.

En outre, l'expérimentateur peut viser exactement une épaisseur de CdTe cristallisé en définissant le poids du soluté au départ et en ajustant le poids du solvant pour respecter la concentration de la charge choisie. C'est en effet la quantité du soluté qui définit l'épaisseur souhaitée.

Il est toutefois à noter que le principe de fonctionnement décrit ci-dessus n'est valable que dans le domaine de température où le flux de tellure sortant de la charge liquide est supérieur au flux de cadmium, générant ainsi une variation de composition de la charge ($xTe_{liquide}$ décroît) telle que la température d'équilibre associée tend à croître. Il est donc nécessaire que la pression partielle du solvant soit supérieure à celle de l'autre composant dans ce domaine de température.

Côté riche en tellure, cette situation n'est vraie que si la température d'équilibre de la charge binaire Cd-Te initiale est inférieure à 1040°C environ. Au-delà et jusqu'à 1090°C (considéré comme le point de fusion du CdTe), c'est le phénomène inverse qui se produit : le flux de cadmium sortant de la charge est supérieur au flux de tellure, ce qui génère une variation de la composition de la charge ($xTe_{liquide}$ croît) telle que la température d'équilibre associée tend à décroître, ce qui ne provoque aucune force motrice pour la cristallisation.

La charge dont la composition à la température d'équilibre égale à environ 1040°C présente la particularité d'avoir des flux de tellure et de cadmium égaux. Elle doit être exclue également du procédé tel que décrit par l'invention.

Dans le cas de la composition ternaire CdZnTe, les solutions liquides doivent également avoir une composition initiale telle que la température d'équilibre tend à croître par perte de tellure (le flux de tellure est supérieur au flux de cadmium).

On va maintenant donner un exemple de réalisation précis. Le creuset est chargé d'une solution de 66,63 g de Cd et de Te contenant également des éléments dopants appropriés. La composition de la solution est de xTe = 0,62 et correspond à une température d'équilibre de 975°C. Le creuset est mis en place dans le four vertical à deux zones de chauffe illustré par la figure 2A. Un profil thermique tel que celui montré sur la figure 2B est assuré pendant la montée en température. Ensuite la zone supérieure de chauffe est réglée de façon à assurer une température de 975°C au fond du creuset ainsi qu'un léger profil thermique de 1°C/cm croissant sur la hauteur du creuset.

Le volume de solution chargée représente une flaque liquide de 3 mm d'épaisseur environ. On peut donc dire que, dans le faible gradient thermique imposé, la solution est quasi isotherme.

Pendant toute la durée de l'expérience (à savoir 15 heures), la température de 975°C est maintenue. La pression interne au réacteur est régulée à 0,85 atm. et maintenue par circulation d'argon au débit de 400 $cm^3$/minute. Au terme de ces 15 heures, un abaissement programmé de la température des deux zones du four ramène à la température ambiante le creuset contenant un disque de CdTe d'environ 65 mm de diamètre et pesant 53,37 g. Ainsi, 13,26 g sont perdus en phase vapeur, ce qui correspond pratiquement à l'évaporation du solvant tellure.

Le disque de CdTe obtenu subit ensuite un léger doucissage mécanique de ses deux faces. Il apparaît une structure cristalline constituée de plusieurs larges grains. Son épaisseur est alors de 2,5 mm.

Une première caractérisation électrique, faite à l'aide de plots d'or, montre une résistivité de $10^{10}$ Ω.cm très homogène sur le disque de CdTe. De plus, un effet photosensible caractérise ce matériau. Ces deux critères sont indispensables au bon fonctionnement de détecteurs de rayonnements X et γ. Sur une impulsion de rayonnement X de 100 kV, 29 mA, 500 ms, le matériel ci-dessus polarisé sous une tension de 36 volts, donne un signal parfaitement carré de 12 mV, sans traînage. Ce matériau est donc tout à fait adapté à la détection X. Des performances semblables sont attendues sous rayonnement $\gamma$, pour un matériau plus épais.

## Revendications

1. Procédé de croissance d'un matériau massif semi-conducteur de type II-VI comprenant au moins un premier composant et un deuxième composant, le procédé comprenant les étapes suivantes :

   - fourniture dans un creuset (11) d'une charge (12) comprenant lesdits composants, les proportions des composants dans la charge (12) étant telles que le premier composant sert de solvant,
   - mise en place du creuset (11) dans un réacteur (1) du type dit "tube ouvert",
   - montée en température du réacteur (1) pour obtenir un profil de température dans le réacteur assurant la fusion de la charge (12) dans le creuset (11) et amorçant l'évaporation du premier composant servant de solvant, la pression à l'intérieur du réacteur étant ajustée, par circulation d'un gaz, pour que les pressions partielles des composants à la température de croissance soient inférieures à la pression atmosphérique, la pression partielle du premier composant étant supérieure à la pression partielle du deuxième composant, le profil de température étant tel que la charge fondue est gardée à la température de croissance, égale ou légèrement supérieure à sa température d'équilibre et inférieure à la température de fusion du matériau désiré, le profil de température étant aussi tel que le creuset (11) présente un point froid où se produit la germination et la croissance du matériau, le réacteur (1) possédant également un point froid permettant la condensation du solvant.

2. Procédé selon la revendication 1, **caractérisé en ce que** la montée en température se fait en deux périodes successives :

   - une première période pendant laquelle le profil de température est tel que la charge (12) dans le creuset (11) commence à fondre et le premier composant à s'évaporer, une zone du réacteur (1) située entre le creuset et le point froid permettant la condensation du solvant étant portée à une température supérieure à la température du creuset afin de constituer un bouchon thermique ;
   - une deuxième période pendant laquelle la charge (12) du creuset (11) est portée à ladite température de croissance, ladite zone du réacteur située entre le creuset et le point froid du réacteur (1) se trouvant à une température inférieure à la température de croissance pour permettre la condensation du solvant.

3. Procédé selon la revendication 2, **caractérisé en ce que** le profil de température est assuré par un four (3) possédant deux zones de chauffe (4, 5).

4. Procédé selon la revendication 3, **caractérisé en ce que** le profil de température est assuré dans un four vertical (3) possédant une zone de chauffe supérieure (4), correspondant à la position du creuset, et une zone de chauffe inférieure (5) située entre la position du creuset (11) et le point froid du réacteur.

5. Procédé selon la revendication 1, **caractérisé en ce que** ladite température de croissance est une température constante.

6. Procédé selon la revendication 1, **caractérisé en ce que** la pression à l'intérieur du réacteur (1) est ajustée en fonction de la vitesse d'évaporation désirée pour le solvant.

7. Procédé selon la revendication 1, **caractérisé en ce que** la pression à l'intérieur du réacteur (1) est ajustée par circulation d'argon.

8. Procédé selon la revendication 1, **caractérisé en ce que** ladite charge (12) fournie dans le creuset (11) comprend également au moins une impureté dopante dont la pression de vapeur est inférieure à la pression de vapeur des composants.

9. Procédé selon la revendication 8, **caractérisé en ce que** ladite charge (12) fournie dans le creuset (11) comprend également au moins une impureté dopante choisie parmi Ti, V, Cr, Mn, Fe, Co, Ni, Cu, Ga, Ge, Al, In, Ag, Au, Tl, Si, Sn, Pb, Bi, Li, Na, K, Be, Mg et Ca.

10. Procédé selon la revendication 1, **caractérisé en ce que**, au moment de la fourniture de ladite charge (12) dans le creuset (11), un germe est introduit au fond du creuset pour favoriser la monocristallisation.

11. Procédé selon la revendication 1, **caractérisé en ce que** le premier composant est du tellure et le deuxième composant est du cadmium.

12. Procédé selon la revendication 11, **caractérisé en ce que** le matériau semi-conducteur comprend aussi un troisième composant qui est le zinc.

## Claims

1. A growth method for a bulk II-VI type semiconductor material, including at least a first component and a second component, with the method including the following steps:

   - suppling in a crucible (11) of a charge (12) including said components, with the proportions of the components in the charge (12) being such that the first component is used as a solvent,
   - placing of the crucible (11) in a so-called "open tube" reactor,
   - raising of the reactor temperature to obtain a temperature profile in the reactor (1) ensuring the melting of the charge (12) in the crucible (11) and with the evaporation of the first component beginning, with the pressure inside the reactor being adjusted by the circulation of a gas so that the partial pressures of the components at the growth temperature will be lower than the atmospheric pressure, with the partial pressure of the first component being greater than the partial pressure of the second component, the temperature profile being such that the melted charge is kept at the growth temperature equal to or slightly higher than its balance temperature and lower than the melting temperature of the desired material, with the temperature profile also being such that the crucible (11) will show a cold point where the germination and the growth of the material take place, with the reactor (1) also having a cold point thereby allowing the condensation of the solvent.

2. Method according to claim 1, **characterised in that** the rise in the temperature is performed in two successive periods:

   - a first period during which the temperature profile is such that the charge (12) in the crucible (11) begins to melt and the first component begins to evaporate, with one zone in the reactor (1) located between the crucible and the cold point allowing the condensation of the solvent to be raised to a temperature higher than the temperature of the crucible so as to forum a heat barrier;
   - a second period during which the charge (12) in the crucible (11) is brought up to said growth temperature, with said zone in the reactor located between the crucible and the cold point of the reactor (1) being kept at a temperature lower than the growth temperature in order to allow the condensation of the solvent.

3. Method according to claim 2, **characterised in that** the temperature profile is ensured by a furnace (3) that has two heating zones (4, 5).

4. Method according to claim 3, **characterised in that** the temperature profile is ensured in an vertical furnace (3), which has an upper heating zone (4), corresponding to the position of the crucible, and a lower heating zone (5) located between the position of the crucible (11) and the cold point of the reactor.

5. Method according to claim 1, **characterised in that** said growth temperature is a constant temperature.

6. Method according to claim 1, **characterised in that** the pressure on the inside of the reactor (1) is adjusted according to the evaporation speed desired for the solvent.

7. Method according to claim 1, **characterised in that** the pressure on the inside of the reactor (1) is adjusted by the circulation of jargon.

8. Method according to claim 1, **characterised in that** said charge (12) supplied in the crucible (11) also includes at least one doping impurity whose vapour pressure is lower than the vapour pressure of the components.

9. Method according to claim 8, **characterised in that** said charge (12) supplied in the crucible (11) also includes at least one doping impurity chosen from among : Ti, V, Cr, Mn, Fe, Co, Ni, Cu, Ga, Ge, Al, In, Ag, Au, Tl, Si, Sn, Pb, Bi, Li, Na, K, Be, Mg and Ca.

10. Method according to claim 1, **characterised in that**, at the time of supplying said charge (12) in the crucible (11), a seed is introduced in the bottom of the crucible to flavour single crystal growth.

11. Method according to claim 1, **characterised in that** the first component is tellurium and the second component is cadmium.

12. Method according to claim 11, **characterised in that** the semiconductor material also includes a third component that is zinc.

## Patentansprüche

1. Verfahren zum Züchten eines massiven Halbleitermaterials des Typs Ii-VI, umfassend mindestens eine erste Komponente und eine zweite Komponente, wobei das Verfahren die folgenden Schritte umfasst:

   - Einbringen einer Charge (12), die die Komponenten umfasst, in einen Schmelztiegel (11), wobei die Anteils der Komponenten in der Charge (12) so sind, dass die erste Komponente als Lösungsmittel dient,
- Anordnen des Schmelztiegels (11) in einem Reaktor (1) des sogenannten "offenes Rohr"-Typs,
- Erhöhen der Temperatur des Reaktors (1), um ein Temperaturprofil in dem Reaktor zu erreichen, das das Schmelzen der Charge (12) in dem Schmelztiegel (11) gewährleistet und die Verdampfung der ersten Komponente, die als Lösungsmittel dient, in Gang setzt, wobei der Druck im Inneren des Reaktors durch die Zirkulation eines Gases so eingestellt wird, dass die Partialdrücke der Komponenten bei der Züchtungstemperatur geringer als Atmosphärendruck sind, der Partialdruck der ersten Komponente über dem Partialdruck der zweiten Komponente ist, das Temperaturprofil so ist, dass die geschmolzene Charge bei der Züchtungstemperatur gehalten wird, gleich oder leicht über seiner Gleichgewicttistemperatur und unter der Schmelztemperatur des gewünschten Materiales, wobei das Temperaturprofil auch so ist, dass der Schmelztiegel (11) einen Kältepunkt aufweist, wo die Keimbildung und die Züchtung des Materiales sich entwickelt, wobei der Reaktor (1) ebenfalls einen Kältepunkt aufweist, der die Kondensation des Lösungsmittels erlaubt.

2. Verfahren nach Anspruch 1, **dadurch gekennzeichnet, dass** die Erhöhung der Temperatur in zwei aufeinanderfolgenden Perioden stattfindet:

    - eine erste Periode, während welcher das Temperaturprofil so ist, dass die Charge (12) in dem Schmelztiegel (11) zu schmelzen und die erste Komponente zu verdampfen beginnt, wobei eine Zone des Reaktors (1), die zwischen dem Schmelztiegel und dem Kältepunkt angeordnet ist, die Kondensation des Lösungsmittels erlaubt, das auf eine Temperatur über der des Schmelztiegels gebracht wird, um einen thermischen Rückstau aufzubauen;
    - eine zweite Periode, während welcher die Charge (12) des Schmelztiegels (11) auf die Züchtungstemperatur gebracht wird, wobei sich die Reaktorzone, die zwischen dem Schmelztiegel und dem Kältepunkt des Reaktors (1) angeordnet ist, bei einer Temperatur befindet, die unter der Züchtungstemperatur ist, um die Kondensation des Lösungsmittels zu erlauben.

3. Verfahren nach Anspruch 2, **dadurch gekennzeichnet, dass** das Temperaturprofil gewährleistet wird durch einen Ofen (3) der zwei Heizzonen (4, 5) aufweist.

4. Verfahren nach Anspruch 3, **dadurch gekennzeichnet, dass** das Temperaturprofil in einem vertikalen Ofen (3) gewährleistet wird, der eine obere Heizzone (4), die der Position des Schmelztiegels entspricht, und eine untere Heizzone (5), die zwischen der Position des Schmelztiegels und dem Kältepunkt des Reaktors angeordnet ist, aufweist.

5. Verfahren nach Anspruch 1, **dadurch gekennzeichnet, dass** die Züchtungstemperatur eine konstante Temperatur ist.

6. Verfahren nach Anspruch 1, **dadurch gekennzeichnet, dass** der Druck im Inneren des Reaktors (1) eingestellt wird als Funktion der gewünschten Verdampfungsgeschwindigkeit für das Lösungsmittel.

7. Verfahren nach Anspruch 1, **dadurch gekennzeichnet, dass** der Druck im Inneren des Reaktors (1) eingestellt wird durch Zirkulation von Argon.

8. Verfahren nach Anspruch 1, **dadurch gekennzeichnet, dass** die Charge (12), die im Schmelztiegel (11) bereitgestellt wird, ebenfalls mindestens eine dotierende Verunreinigung umfasst, deren Dampfdruck unter dem Dampfdruck der Komponenten ist.

9. Verfahren nach Anspruch 8, **dadurch gekennzeichnet, dass** die Charge (12), die im Schmelztiegel (11) bereitgestellt wird, ebenfalls mindestens eine dotierende Verunreinigung umfasst, ausgewählt aus Ti, V, Cr, Mn, Fe, Co, Ni, Cu, Ga, Ge, Al, In, Ag, Au, Ti, Si, Sn, Pb, Bi, Li, Na, K, Be, Mg und Ca.

10. Verfahren nach Anspruch 1, **dadurch gekennzeichnet, dass** im Moment der Bereitstellung der Charge (12) im Schmelztiegel (11) ein Keim am Boden des Tiegels eingebracht wird, um die Monokristallisation zu begünstigen.

11. Verfahren nach Anspruch 1, **dadurch gekennzeichnet, dass** die erste Komponente aus Tellur ist und die zweite Komponente aus Cadmium ist.

12. Verfahren nach Anspruch 11, **dadurch gekennzeichnet, dass** das Halbleitermaterial auch eine dritte Komponente umfasst, die Zink ist.

FIG. 1

FIG. 3

FIG. 2A    FIG. 2B    FIG. 2C

EP 1 349 970 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M.R. LORENZ.** Préparation of CdTe Crystals from Near Stoichiometric and Cd Rich Melt Compositions under Constant Cd Pressure. *Journal of Applied Physics,* Novembre 1962, vol. 33 (11), 3304-3306
- **B. LUNN et al.** Growth of Cadmium Telluride by Solvent Evaporation. *Revue de Physique Appliquée,* Février 1977, 151-154

- **J.B. MULLIN et al.** Crystal Growth and Characterisation of Cadmium Telluride : a Modified Solvent Evaporation Technique. *Journal of Crystal Growth,* 1982, vol. 59, 135-142
- **A.W. VERE et al.** Growth of CdTe by Solvent Evaporation. *Journal of Crystal Growth,* 1985, vol. 72, 97-101